# EUROPÄISCHE PATENTSCHRIFT

(11) **EP 0 478 821 B1**
(45) Veröffentlichungstag und Bekanntmachung des Hinweises auf die Patenterteilung: **06.09.1995**
(21) Anmeldenummer: 90118890.4
(22) Anmeldetag: 02.10.1990
(51) Int. Cl.: H03D 1/22

(54) **Einrichtung zur Synchrondemodulation amplitudenmodulierter Signale**
Device for synchrodyne demodulation of amplitude modulated signals
Dispositif pour la démodulation synchrone de signaux modulés en amplitude

(43) Veröffentlichungstag der Anmeldung: 08.04.1992
(73) Patentinhaber: SIEMENS AKTIENGESELLSCHAFT, 80333 München (DE)
(72) Erfinder: Stepp, Richard, Dipl.-Ing., W-8000 München 40 (DE)

(56) Entgegenhaltungen:
- EP-A- 0 122 657
- EP-A- 0 282 607
- EP-A- 0 371 548
- GB-A- 2 099 245
- US-A- 4 072 909
- US-A- 4 091 410
- US-A- 4 470 145

## Beschreibung

Die Erfindung betrifft eine Einrichtung zur Synchrondemodulation amplitudenmodulierter Signale nach den Merkmalen des Oberbegriffs des Anspruchs 1.

Der wesentliche Vorteil der Synchrondemodulation amplitudenmodulierter Signale liegt in der Vermeidung von Modulationsverzerrungen und zwar insbesondere bei Restseitenbandsystemen, wie z. B. Fernsehsystemen. Solche Modulationsverzerrungen sind mit den bekannten Hüllkurven- oder Quasisynchrondemodulationsverfahren grundsätzlich nicht zu vermeiden.

Bei der Synchrondemodulation selbst ist es notwendig, die Trägerfrequenz schmalbandig aus dem Modulationsspektrum des amplitudenmodulierten Signales herauszufiltern und einen Oszillator damit zu synchronisieren, in dem das Ausgangssignal des Oszillators als regeneriertes Trägersignal neben dem zu demodulierenden amplitudenmodulierten Signal einem Demodulatormischer zugeführt wird.

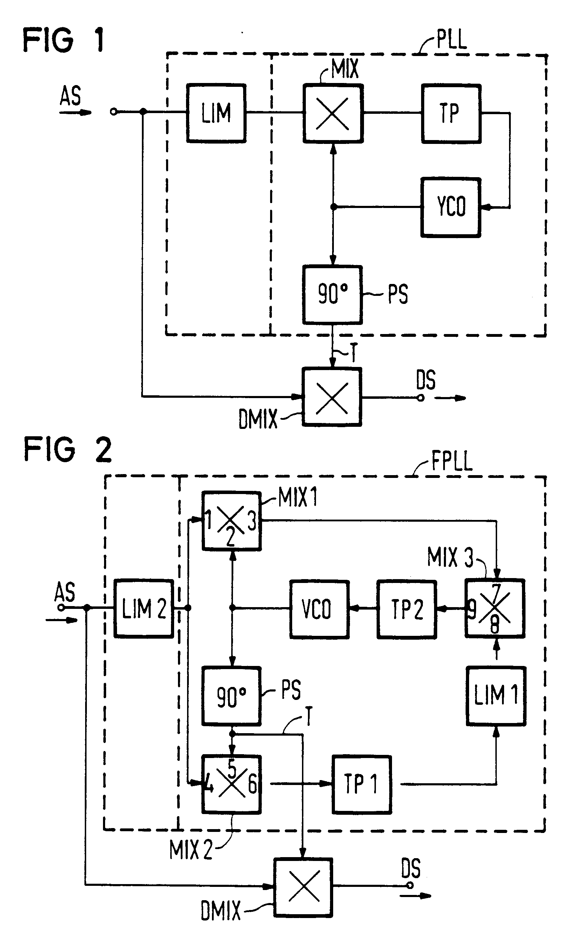

Um dieses notwendige Trägersignal bei der Synchrondemodulation zu regenerieren, ist es allgemein bekannt, Phasenregelkreise, sogenannte PLLs, einzusetzen. Eine einfache PLL besteht, wie in FIG 1 dargestellt, aus einer Mischereinrichtung MIX der ein zu demodulierendes amplitudenmoduliertes Signal AS, gegebenenfalls über einen Begrenzer LIM breitbandig oder schmalbandig begrenzt zugeführt wird. Ausgangsseitig ist diese Mischereinrichtung MIX über einen Tiefpaß TP mit nachgeschaltetem i. a. spannungsgesteuertem Oszillator VCO verbunden, dessen Ausgangssignal als weiteres Eingangssignal der Mischereinrichtung MIX zugeführt wird. Das Ausgangssignal des spannungsgesteuerten Oszillators VCO wird über einen 90°-Phasenschieber PS als regeneriertes Trägersignal T einer Demodulatormischereinrichtung DMIX zugeführt. Zusätzlich wird dieser Demodulatormischereinrichtung DMIX das zu demodulierende amplitudenmodulierte Signal AS zugeführt, wodurch am Ausgang der Demodulatormischereinrichtung DMIX ein demoduliertes Ausgangssignal DS zur weiteren Verarbeitung zur Verfügung steht.

Es ist weiterhin bekannt, aus den Parametern eines derartigen Phasenregelkreises die Bandbreite der Trägerfrequenzselektion zu berechnen. Das Frequenzfangverhalten eines solchen Phasenregelkreises ist mit dieser Bandbreite gekoppelt. Dadurch ergibt sich bei einer schmalen Bandbreite auch ein geringes Frequenzfangverhalten des in FIG 1 dargestellten Phasenregelkreises.

Das Frequenzfangverhalten kann mit einer als Frequenzphasenregelkreis FPLL bekannten Anordnung, die beispielsweise in US-PS 4 072 909 beschrieben ist, verbessert werden. Ein derartiger Frequenzphasenregelkreis FPLL ist in FIG 2 dargestellt.

Das zu demodulierende amplitudenmodulierte Signal AS wird gegebenenfalls von einer Begrenzereinrichtung LIM2 begrenzt den Eingangsklemmen 1, 4 einer ersten Mischereinrichtung MIX1 und einer zweiten Mischereinrichtung MIX2 zugeführt. Der Frequenzphasenregelkreis FPLL verfügt über eine dritte Mischereinrichtung MIX3, deren erste Eingangsklemme 7 mit einer Ausgangsklemme 3 der ersten Mischereinrichtung MIX1 verbunden ist. Die zweite Eingangsklemme 8 der dritten Mischereinrichtung MIX3 ist mit einer Ausgangsklemme 6 der zweiten Mischereinrichtung MIX2 über einen ersten Tiefpaß TP1 und eine weitere Begrenzereinrichtung LIM1 in Verbindung. Eine Ausgangsklemme 9 der dritten Mischereinrichtung MIX3 ist mit einem zweiten Tiefpaß TP2 in Verbindung, deren Ausgang an einen steuerbaren Oszillator VCO, insbesondere einen spannungsgesteuerten Oszillator, geschaltet ist. Das Ausgangssignal dieses steuerbaren Oszillators VCO gelangt zum einen direkt an eine zweite Eingangsklemme 2 der ersten Mischereinrichtung MIX1 und über eine Phasenschiebereinrichtung PS um 90° phasenverschoben an eine zweite Eingangsklemme 5 der zweiten Mischereinrichtung MIX2. Am Ausgang dieser Phasenschiebereinrichtung steht das regenerierte Trägersignal T zur Verfügung, um in einer Demodulatormischereinrichtung DMIX das dort zugeführte amplitudenmodulierte Signal AS zu demodulieren. Am Ausgang dieser Demodulatormischereinrichtung DMIX ist das demodulierte Signal zur weiteren Verarbeitung abgreifbar.

Wesentlich bei diesem Frequenzphasenregelkreis FPLL ist der Phasengang des Tiefpasses TP1. Zum Beispiel kann TP1 ein Tiefpaß zweiter Ordnung mit nachfolgendem Begrenzer sein.

Im vorliegenden Fall bestimmt der zweite Tiefpaß TP2 zusammen mit den restlichen Parametern des Frequenzphasenregelkreises FPLL die Bandbreite der Trägerselektion, während das erste Tiefpaßfilter TP1 in Verbindung mit der weiteren Begrenzereinrichtung LIM1 und den restlichen Parametern der Schaltungsanordnung das Frequenzfangverhalten bestimmt. Wesentlich ist hierbei, daß sowohl das Frequenzfangverhalten als auch die Bandbreite weitgehend voneinander unabhängig gewählt werden kann.

Nachteilig bei dieser Schaltung sind die zwei auftretenden stabilen Phasenrastpunkte bei einer Phasenverschiebung 0 und Π Eine Möglichkeit, diese ungewollten Phasenzufälligkeiten auszuschließen, ist z. B. aus dem US-PS 4 091 410 bekannt.

Der Erfindung liegt die Aufgabe zugrunde, eine weitere Möglichkeit anzugeben, wie die erwähnten Phasenzufälligkeiten ausgeschlossen werden können, bei weitgehend unabhängiger Wahl von Bandbreite und Frequenzfangverhalten.

Diese Aufgabe wird durch die kennzeichnenden Merkmale des Anspruchs 1 gelöst.

Weiterbildungen der Erfindung sind Gegenstand der Unteransprüche.

Der wesentliche Vorteil der erfindungsgemäßen Einrichtung liegt darin, daß das Frequenzfangverhalten im unsynchronisierten Zustand durch das im Frequenzphasenregelkreis liegende Tiefpaßfilter und den Schleifenparametern bestimmt wird. Durch die erfindungsgemäße Summationseinrichtung ergibt sich nur ein stabiler Phasenrastpunkt, so daß eine Phasenzufälligkeit ausgeschlossen wird.

Die Erfindung wird im folgenden anhand von weiteren fünf Figuren näher erläutert. Es zeigen:
- FIG 3: ein erstes Beispiel für eine erfindungsgemäße Einrichtung im Blockschaltbild mit eingangsseitiger Begrenzereinrichtung,
- FIG 4: ein zweites Beispiel für eine erfindungsgemäße Einrichtung im Blockschaltbild ohne eingangsseitigen Begrenzer,
- FIG 5: Ausgangssignal an der Ausgangsklemme 3 der ersten Mischereinrichtung des Phasenregelkreises PLL,
- FIG 6: Ausgangssignal an der weiteren Begrenzereinrichtung des Frequenzphasenregelkreises FPLL, und
- FIG 7: Ausgangssignal an der Ausgangsklemme der dritten Mischereinrichtung.

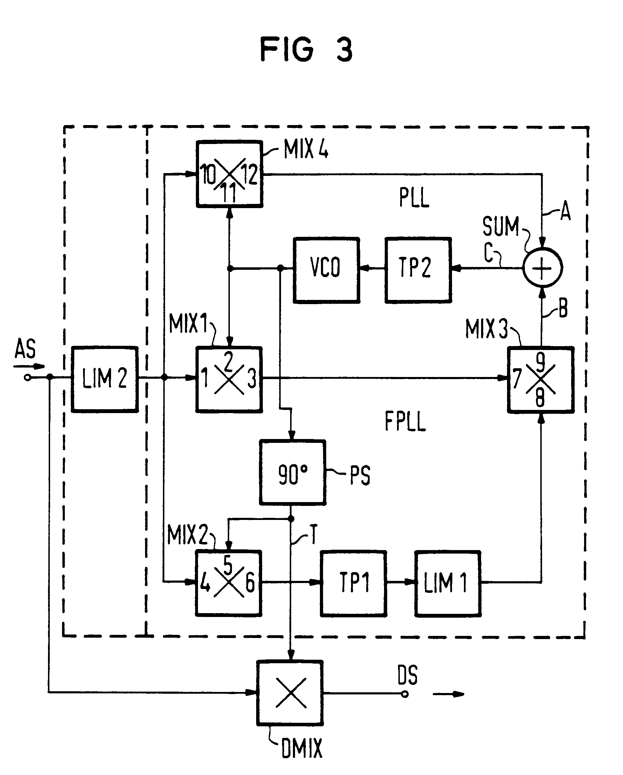

Ein erstes Ausführungsbeispiel einer erfindungsgemäßen Einrichtung zur Synchrondemodulation amplitudenmodulierter Signale zeigt FIG 3. Dort ist ein erster Phasenregelkreis FPLL zur Trägerregenerierung vorgesehen, bei dem das amplitudenmodulierte Signal AS über eine nicht unbedingt notwendige Begrenzereinrichtung LIM2 jeweils den ersten Eingangsklemmen 1, 4 einer ersten und zweiten Mischereinrichtung MIX1, MIX2 zugeführt wird. Eine Ausgangsklemme 3 der ersten Mischereinrichtung MIX1 ist mit einer ersten Eingangsklemme 7 einer dritten Mischereinrichtung MIX3 verbunden, während eine Ausgangsklemme 6 der zweiten Mischereinrichtung MIX2 über einen ersten Tiefpaß TP1 und eine weitere Begrenzereinrichtung LIM1 an eine zweite Eingangsklemme 8 der dritten Mischereinrichtung MIX3 geschaltet ist. Eine Ausgangsklemme 9 der dritten Mischereinrichtung MIX3 ist über eine weiter unten noch zu erläuternde Summationseinrichtung SUM über einen zweiten Tiefpaß TP2 und einen steuerbaren Oszillator VCO direkt an eine zweite Eingangsklemme 2 der ersten Mischereinrichtung und um 90° phasenverschoben mittels eines Phasenschiebers PS an eine zweite Eingangsklemme 5 der zweiten Mischereinrichtung MIX2 geschaltet. Am Ausgang des Phasenschiebers PS liegt das regenerierte Trägersignal T an, das einem Demodulatormischer DMIX zugeführt wird. Zusätzlich wird diesem Demodulatormischer DMIX das amplitudenmodulierte Signal AS zugeführt, wodurch am Ausgang des Demodulatormischers DMIX ein demoduliertes Signal abgreifbar ist. Dieser bisher beschriebene erste Phasenregelkreis entspricht - abgesehen von der wie erwähnt noch zu erläuternden Summationseinrichtung SUM - dem Frequenzphasenregelkreis von FIG 2.

Erfindungsgemäß wird dieser erste Phasenregelkreis FPLL um einen zweiten Phasenregelkreis PLL derart erweitert, daß die geforderte Phasenzufälligkeit ausgeschlossen wird. Dazu weist der zweite Phasenregelkreis eine vierte Mischereinrichtung MIX4 mit zwei Eingangsklemmen 10, 11 und eine Ausgangsklemme 12 auf, wobei deren erste Eingangsklemme 10 das gleiche Eingangssignal wie der ersten und zweiten Mischereinrichtung MIX1, MIX2 zugeführt wird, hier also das durch die Begrenzereinrichtung LIM2 begrenzte amplitudenmodulierte Signal AS. Die zweite Eingangsklemme 11 der vierten Mischereinrichtung MIX4 ist wie die erste Mischereinrichtung MIX1 direkt mit dem Ausgang des steuerbaren Oszillators VCO verbunden. Das an der Ausgangsklemme 12 der vierten Mischereinrichtung MIX4 abgreifbare Signal A gelangt wie das an der Ausgangsklemme 9 der dritten Mischereinrichtung MIX3 abgreifbare Signal B an jeweils einen Eingang der oben bereits kurz erwähnten Summationseinrichtung SUM. Das Summensignal C der beiden Signale A und B wird dem zweiten Tiefpaß TP2 zugeführt.

Damit ergibt sich eine Einrichtung zur Synchrondemodulation amplitudenmodulierter Signale mit einem Frequenzphasenregelkreis FPLL und einem weiteren Phasenregelkreis PLL, die derart miteinander kombiniert sind, daß sich eine möglichst schaltungstechnisch einfache Realisierung ergibt. Dies wird insbesondere dadurch erreicht , daß der zweite Tiefpaß TP2 und steuerbare Oszillator VCO von beiden Phasenregelkreisen FPLL, PLL benutzt wird.

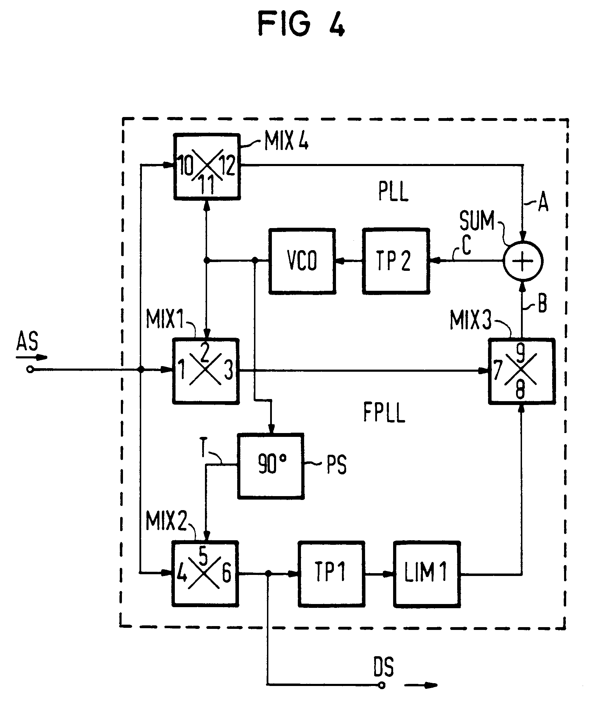

Ein zweites Ausführungsbeispiel einer erfindungsgemäßen Einrichtung zur Synchrondemodulation amplitudenmodulierter Signale zeigt FIG 4. Diese Einrichtung weist im Gegensatz zu der in FIG 3 dargestellten Einrichtung keine eingangsseitige Begrenzereinrichtung auf. Vielmehr wird das amplitudenmodulierte Signal AS direkt den Eingangsklemmen 1, 4, 10 der ersten, zweiten und vierten Mischereinrichtung MIX1, MIX2 und MIX4 zugeführt. Darüberhinaus wird das demodulierte Signal an der Ausgangsklemme 6 der zweiten Mischereinrichtung MIX2 abgegriffen. Damit dient die zweite Mischereinrichtung MIX2 zugleich als Demodulatormischereinrichtung.

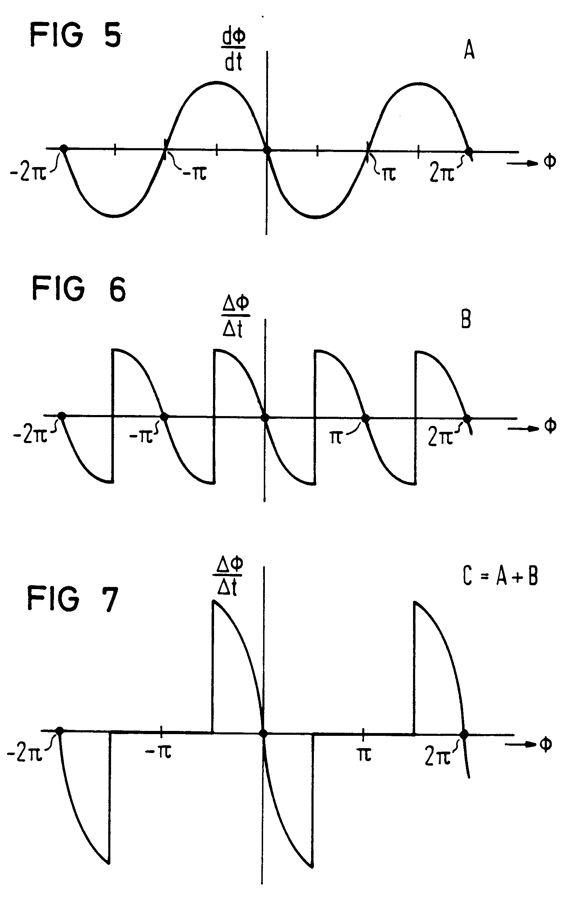

Die Wirkungsweise der erfindungsgemäßen Einrichtung wird anhand einer Darstellung der Signale an den Ausgängen 9 und 12 der dritten und vierten Mischereinrichtung MIX3, MIX4 sowie des Signales am Ausgang der Summationseinrichtung SUM deutlich. In den FIG 5 bis 7 sind auf den Abszissen jeweils der Phasenwinkel 0̸ und auf deren Ordinaten die erste zeitliche Ableitung davon aufgetragen. Dabei ergibt sich für den zweiten Phasenregelkreis PLL der in FIG 5 dargestellte Verlauf mit einem stabilen Phasenrastpunkt bei einer Phasenverschiebung 0̸ = 0, ± 2π und ganzen Vielfachen davon, während bei ± π, ± 3π usw. ein labiler Phasenrastpunkt auftritt. Dort würde der zweite Phasenregelkreis nicht einrasten, wohl dagegen bei den stabilen Phasenrastpunkten.

FIG 6 zeigt den Phasendetektorausgang für das Signal B. Hier treten sowohl bei einer Phasenverschiebung 0 und π stabile Phasenrastpunkte auf, die es erfindungsgemäß auszuschließen gilt.

In FIG 7 ist der Phasendetektorausgang des Signales C dargestellt. Es ist deutlich zu erkennen, daß durch die Summation der Signale A (vgl. FIG 5) und B (vgl. FIG 6) sich nur ein stabiler Phasenrastpunkt bei einer Phasenverschiebung 0 ergibt.

Im frequenzsynchronisierten Zustand ist das Ausgangssignal des Begrenzers LIM1 eine Gleichspannung. Damit wirkt die dritte Mischeinrichtung MIX3 als Multiplikation mit ± 1. Im Fall von +1 werden die Ausgangssignale A und B identisch und die Einrichtung verhält sich wie ein gewöhnlicher Phasenregelkreis, wie dieser in FIG 1 dargestellt ist. Im Fall -1 gibt dagegen die Summe der Signale A und B identisch 0, wobei dieser Zustand nicht stabil ist.

## Patentansprüche

1. Einrichtung zur Synchrondemodulation amplitudenmodulierter Signale mit
- einem ersten Phasenregelkreis (FPLL) zur Trägerregenerierung, bei dem das amplitudenmodulierte Signal (AS) Jeweils den ersten Eingangsklemmen (1, 4) einer ersten und zweiten Mischeinrichtung (MIX1, MIX2) zuführbar ist; eine Ausgangsklemme (3) der ersten Mischeinrichtung (MIX1) mit einer ersten Eingangsklemme (7) einer dritten Mischeinrichtung (MIX3) verbunden ist; eine Ausgangsklemme (6) der zweiten Mischeinrichtung (MIX2) über einen ersten Tiefpaß (TP1) und eine Begrenzereinrichtung (LIM1) an eine zweite Eingangsklemme (8) der dritten Mischeinrichtung (MIX3) geschaltet ist und eine Ausgangsklemme (9) der dritten Mischeinrichtung (MIX3) über einen zweiten Tiefpaß (TP2) und steuerbaren Oszillator (VCO) direkt an die zweite Eingangklemme (2) der ersten Mischeinrichtung (MIX1) und um 90° phasenverschoben als regeneriertes Trägersignal (T) an die zweite Eingangsklemme (5) der zweiten Mischeinrichtung (MIX2) geschaltet ist; und
- einem Demodulatormischer (DMIX), dem einerseits das amplitudenmodulierte Signal (AS) und andererseits das um 90° phasenverschobene regenerierte Trägersignal (T) zuführbar und an dessen Ausgangsklemme ein demoduliertes Signal (DS) abgreifbar ist
**gekennzeichnet** durch:
- einen zweiten Phasenregelkreis (PLL) mit einer zwei Eingangsklemmen (10, 11) und eine Ausgangsklemme (12) aufweisenden vierten Mischereinrichtung (MIX4), an deren erste Eingangsklemme (10) das amplitudenmodulierte Signal (AS) und an deren zweite Eingangsklemme (11) ein am steuerbaren Oszillator (VCO) abgreifbares Signal zuführbar ist, und
- eine Summationseinrichtung (SUM), durch die die an der Ausgangsklemme (9) der dritten Mischereinrichtung (MIX3) und an der Ausgangsklemme (12) der vierten Mischereinrichtung (MIX4) abgreifbaren Signale (A, B) als Summensignal (C) dem zweiten Tiefpaß (TP2) zuführbar ist.

2. Einrichtung zur Synchrondemodulation amplitudenmodulierter Signale nach Anspruch 1,
**dadurch gekennzeichnet,**
daß die zweite Mischereinrichtung (MIX2) zugleich der Demodulatormischer (DMIX) ist, an dessen Ausgangsklemme (6) das demodulierte Signal (DS) abgreifbar ist.

3. Einrichtung zur Synchrondemodulation amplitudenmodulierter Signale nach Anspruch 1,
**dadurch gekennzeichnet**,
daß das amplitudenmodulierte Signal (AS) den Eingangsklemmen (1, 4, 10) der ersten, zweiten und vierten Mischereinrichtung (MIX1, MIX2, MIX4) über eine zweite Begrenzereinrichtung (LIM2) zuführbar ist.

## Claims

1. Device for synchronous demodulation of amplitude-modulated signals, having
- a first phase-locking loop (FPLL) for carrier regeneration, in which the amplitude-modulated signal (AS) can be fed in each case to the first input terminals (1, 4) of a first and second mixer device (MIX1, MIX2); an output terminal (3) of the first mixer device (MIX1) is connected to a first input terminal (7) of a third mixer device (MIX3); an output terminal (6) of the second mixer device (MIX2) is connected via a first low-pass filter (TP1) and a limiter device (LIM1) to a second input terminal (8) of the third mixer device (MIX3) and an output terminal (9) of the third mixer device (MIX3) is connected via a second low-pass filter (TP2) and controllable oscillator (VCO) directly to the second input terminal (2) of the first mixer device (MIX1) and, phase-shifted by 90°, as a regenerated carrier signal (T) to the second input terminal (5) of the second mixer device (MIX2); and
- a demodulator mixer (DMIX) to which, on the one hand, the amplitude-modulated signal (AS) and, on the other hand, the regenerated carrier signal (T) phase-shifted by 90°, can be fed and at the output terminal of which a demodulated signal (DS) can be picked up
characterized by:
- a second phase-locking loop (PLL) having a fourth mixer device (MIX4), which has two input terminals (10, 11) and one output terminal (12), to the first input terminal (10) of which the amplitude-modulated signal (AS) can be fed, and to the second input terminal (11) of which a signal which can be picked up from the controllable oscillator (VCO) can be fed, and
- a summation device (SUM), via which the signals (A, B) which can be picked up from the output terminal (9) of the third mixer device (MIX3) and from the output terminal (12) of the fourth mixer device (MIX4) can be fed as a sum signal (C) to the second low-pass filter (TP2).

2. Device for synchronous demodulation of amplitude-modulated signals according to Claim 1, characterized in that the second mixer device (MIX2) is simultaneously the demodulator mixer (DMIX), from the output terminal (6) of which the demodulated signal (DS) can be picked up.

3. Device for synchronous demodulation of amplitude-modulated signals according to Claim 1, characterized in that the amplitude-modulated signal (AS) can be fed to the input terminals (1, 4, 10) of the first, second and fourth mixer device (MIX1, MIX2, and MIX4) via a second limiter device (LIM2).

## Revendications

1. Dispositif de démodulation synchrone de signaux modulés en amplitude, comportant
- une première boucle à verrouillage de phase (FPLL) servant à régénérer la porteuse et dans lequel le signal modulé en amplitude (AS) peut être envoyé respectivement aux premières bornes d'entrée (1,4) de premier et second dispositifs mélangeurs (MIX1, MIX2); une borne de sortie (3) du premier dispositif mélangeur (MIX1) est reliée à une première borne d'entrée (7) d'un troisième dispositif mélangeur (MIX3); une borne de sortie (6) du second dispositif mélangeur (MIX2) est reliée par l'intermédiaire d'un premier passe-bas (TP1) et d'un second dispositif limiteur (LIM1) à une seconde borne d'entrée (8) du troisième dispositif mélangeur (MIX3), et une borne de sortie (9) du troisième dispositif mélangeur (MIX3) est raccordée, par l'intermédiaire d'un second passe-bas (TP2) et d'un oscillateur commandable (VCO) directement à la seconde borne d'entrée (2) du premier dispositif mélangeur (MIX1) et, en étant déphasé de 90°, en tant que signal de porteuse régénéré (T), à la seconde borne d'entrée (5) du second dispositif mélangeur (MIX2); et
- un mélangeur-démodulateur (DMIX), auquel peuvent être envoyés d'une part le signal modulé en amplitude (AS) et d'autre part le signal de porteuse régénéré (T) et déphasé de 90°, et sur la borne de sortie duquel peut être prélevé un signal démodulé (DS),
caractérisé par :
- une seconde boucle à verrouillage de phase (PLL) comportant un quatrième dispositif mélangeur (MIX4) comportant deux bornes d'entrée (10,11) et une borne de sortie (12) et à la première borne d'entrée (10) duquel peut être envoyé le signal modulé en amplitude (AS) et à la seconde borne d'entrée (11) duquel peut être envoyé un signal pouvant être prélevé dans l'oscillateur commandable (VCO), et
- un dispositif de sommation (SUM), au moyen duquel les signaux (A,B), qui peuvent être prélevés sur la borne de sortie (9) du troisième dispositif mélangeur (MIX3) et sur la borne de sortie (12) du quatrième dispositif mélangeur (MIX4), peuvent être envoyés en tant que signal somme (C) au second passe-bas (TP2).

2. Dispositif de démodulation synchrone de signaux modulés en amplitude suivant la revendication 1, caractérisé par le fait que le second dispositif mélangeur (MIX2) constitue simultanément le mélangeur-démodulateur (DMIX), sur la borne de sortie (6) duquel peut être prélevé le signal démodulé (DS).

3. Dispositif de démodulation synchrone de signaux modulés en amplitude suivant la revendication 1, caractérisé par le fait que le signal modulé en amplitude (AS) peut être envoyé aux bornes d'entrée (1,4,10) des premier, second et quatrième dispositifs mélangeurs (MIX1, MIX2, MIX4), par l'intermédiaire d'un second dispositif limiteur (LIM2).
